# EUROPEAN PATENT APPLICATION

(11) **EP 4 847 687 A1**
(43) Date of publication of application: **02.12.2026**
(21) Application number: 24920281.3
(22) Date of filing: 23.10.2024
(51) Int. Cl.: D06M 13/513, C03C 25/40, D03D 1/00, D03D 15/267, H05K 1/03

(54) **GLASS CLOTH, PREPREG, AND PRINTED WIRING BOARD**

(30) Priority: 23.01.2024 JP 2024008168
(71) Applicant: ASAHI KASEI KABUSHIKI KAISHA, Tokyo 100-0006 (JP)
(72) Inventor: HIROSE, Amane, Tokyo 100-0006 (JP); HASHIMOTO, Yuka, Tokyo 100-0006 (JP); FUNAMI, Shingo, Tokyo 100-0006 (JP)
(74) Representative: Hoffmann Eitle
(86) International application number: PCT/JP2024/037673
(87) International publication number: WO 2025/158734

(57) **Abstract**

The purpose of the present disclosure is to provide a glass fabric that is capable of realizing excellent dielectric properties and excellent insulation reliability, and that makes it possible to obtain a resin substrate having a small whitening distance. The glass fabric according to the present disclosure is obtained by weaving glass yarn. This glass fabric is surface-treated by a surface treatment agent. A formula A is obtained from the total carbon content in the glass fabric and the carbonyl group-derived peak height as measured by Fourier transform infrared spectroscopy. Formula A: carbonyl group-derived peak height/total glass fabric carbon content is 10 or greater; and the number of white spots P is 10 pcs./m² or less.

## Description

### TECHNICAL FIELD

The present disclosure relates to a glass fabric, a prepreg and a printed circuit board.

### BACKGROUND ART

Current trends continue to progress toward increasingly higher performance of data terminals such as smartphones and higher-speed communication including 5G communication. At the same time, advances are being made in the field of printed circuit boards for high-speed communication, in terms of lower relative permittivity and lower dielectric loss tangents for the insulating materials used to reduce transmission loss, and demand is increased for even higher insulating reliability.

Examples of insulating materials to be used in printed circuit boards for high-speed communication are described in PTLs 1 and 2. Specifically, in both PTLs 1 and 2, a glass fabric is impregnated with a low-dielectric thermosetting resin that is crosslinked by radical reaction with a polyphenylene ether that has been modified at the ends with vinyl or methacryloxy groups, thus becoming hardened by the crosslinking (hereinafter referred to collectively as "matrix resin"), and it is then dried to obtain a prepreg. Laminated sheets are known that are obtained by laminating prepregs obtained in this manner, and curing them by heating and pressing. The goal in PTLs 1 and 2 is to realize low permittivity and a low dielectric loss tangent as a laminated sheet, by combination with a glass fabric having low permittivity and a low dielectric loss tangent.

For the goal of lowering the dielectric loss tangent of a glass fabric, PTLs 3 and 4 report that the amount of silanol groups on a silica glass fabric surface is reduced by heating the glass at high temperature. For the goal of extending the drill life in the step of drilling the glass fabric, PTL 5 reports obtaining glass yarn by spinning glass fibers with a softening point of 1000 to 1600°C, and fabrication of a glass fabric using the glass yarn.

### CITATION LIST

### PATENT LITERATURE

[PTL 1] International Patent Publication No. WO2019/065940
[PTL 2] International Patent Publication No. WO2019/065941
[PTL 3] Japanese Unexamined Patent Publication No. 2021-63320
[PTL 4] Japanese Unexamined Patent Publication No. 2021-195689
[PTL 5] Japanese Unexamined Patent Publication No. 2023-131220

### SUMMARY OF INVENTION

### TECHNICAL PROBLEM

Given that glass fabrics with excellent dielectric characteristics and excellent insulating reliability can be realized using the prior art described in PTLs 1 to 5, there has also been demand for development of technologies capable of producing resin substrates with smaller whitening distance.

The "whitening distance", as a point of focus by the present inventors, is an index representing the degree of interfacial separation between a glass fabric and matrix resin. A glass fabric with more excellent insulating reliability will tend to allow production of resin substrates with smaller whitening distances.

It is an object of the present disclosure to provide a glass fabric that can exhibit excellent dielectric characteristics and excellent insulating reliability, and that also allows a resin substrate with a small whitening distance to be obtained.

It is another object of the disclosure to provide a prepreg and printed circuit board produced using the glass fabric described above, as well as a method for producing the glass fabric.

### SOLUTION TO PROBLEM

According to one aspect of the disclosure it is possible to ensure the dielectric characteristic of a glass fabric while reducing the whitening distance for resin substrates.

Specifically, the present inventors have been the first to find that, by one aspect of the present disclosure, it is possible to provide a glass fabric with excellent insulating reliability, which is also a glass fabric exhibiting an excellent dielectric characteristic and having a small whitening distance in obtained resin substrates.

The following is an example of this aspect of the disclosure.
[1] A glass fabric formed by weaving glass yarn, wherein:
   the glass fabric is surface-treated with a surface treatment agent,
   the value of the following formula A is 10 or greater:
      Formula A = Carbonyl group-derived peak height/total carbon in glass fabric, as calculated from the total carbon content in the glass fabric and the carbonyl group-derived peak height as measured by Fourier transform infrared spectroscopy, and the number of white spots is 10/m² or less.
[2] A glass fabric formed by weaving glass yarn, wherein:
   the glass fabric is surface-treated with a surface treatment agent,
   the value of the following formula B is 11 or greater:
      Formula B = Carbonyl group-derived peak height/ignition loss value of glass fabric, as calculated from the ignition loss value of the glass fabric and the carbonyl group-derived peak height as measured by Fourier transform infrared spectroscopy, and
   the number of white spots is 10/m² or less.
[3] A glass fabric according to [1] or [2], wherein the silicon (Si) content of the glass yarn is 95.0 to 100 mass% in terms of silicon dioxide (SiO₂).
[4] A glass fabric according to any one of [1] to [3], wherein the dielectric loss tangent at 10 GHz is 0.002 or lower.
[5] A glass fabric according to any one of [1] to [4] above, wherein the bulk dielectric loss tangent at 10 GHz of the glass composing the glass yarn is 0.002 or lower.
[6] A glass fabric according to any one of [1] to [5], wherein the surface treatment agent comprises a silane coupling agent.
[7] A glass fabric according to any one of [1] to [6] above, wherein the surface treatment agent comprises a silane coupling agent represented by the following formula (1):

   X₃₋ₙSiYₙ (1)

   (where each X may independently comprise a different organic functional group, with X composed of a functional group having a total of at least two of both a carbonyl group and an unsaturated carbon double bond, each Y is independently an alkoxy group, and n is an integer of 1 to 3).
[8] A glass fabric according to [7] above, wherein the unsaturated carbon double bond is a bond derived from either or both an acryloyl and methacryloyl group.
[9] A glass fabric according to any one of [1] to [8], wherein the ignition loss value of the glass fabric is 0.01 to 0.5 mass%.
[10] A glass fabric according to any one of [1] to [9], wherein the average degree of opening of the warp yarn and weft yarn of the glass fabric is greater than 40%, as calculated from their respective yarn widths.
[11] A glass fabric according to any one of [1] to [10], wherein the total carbon content in the glass fabric is 0.01 to 0.8 mass%.
[12] A prepreg comprising a glass fabric according to any one of [1] to [11], and a matrix resin.
[13] A printed circuit board comprising a prepreg according to [12].
[14] An integrated circuit comprising a printed circuit board according to [13].
[15] An electronic device comprising a printed circuit board according to [13].
[16] A method for producing a glass fabric by weaving glass yarn, the method having:
   a surface treatment step in which the glass yarn is treated using a surface treatment solution containing a surface treatment agent with a molecular weight of 200 or greater,
   wherein the surface treatment step comprises at least one of the following steps:
      a step of adding a solvent to the surface treatment agent to adjust the surface treatment solution;
      a step of controlling the temperature of the surface treatment solution;
      a step of controlling the pH of the surface treatment solution; and
      a step of filtering the surface treatment solution.
[17] The method for producing a glass fabric according to [15], wherein:
   the surface treatment step comprises a step of surface treating the deoiled glass yarn with a surface treatment agent, and
   the surface treatment agent comprises a silane coupling agent represented by the following formula (1):

      X₃₋ₙSiYₙ (1)

      (where each X may independently comprise a different organic functional group, with X composed of a functional group having a total of at least two of both a carbonyl group and an unsaturated carbon double bond, each Y is independently an alkoxy group, and n is an integer of 1 to 3).
[18] The method for producing a glass fabric according to [16] or [17], wherein the surface treatment step comprises:
   a step of controlling the temperature and pH of the surface treatment solution, and
   a step of filtering the surface treatment solution.
[19] The method for producing a glass fabric according to any one of [16] to [18], which further comprises a step of opening the glass yarn after the surface treatment step.
[20] The method for producing a glass fabric according to any one of [16] to [19], which further comprises a step of examining white spots in the glass fabric.
[21] The method for producing a glass fabric according to any one of [16] to [20], which comprises a step of measuring the carbonyl group-derived peak height for the glass fabric, using Fourier transform infrared spectroscopy.
[22] A test method for a glass fabric obtained by weaving glass yarn, wherein
   the glass fabric is surface-treated with a surface treatment agent, and
   the test method comprises a step of examining white spots in the glass fabric based on the carbonyl group-derived peak height for the glass fabric and the total carbon content in the glass fabric or the ignition loss value of the glass fabric.

### ADVANTAGEOUS EFFECTS OF INVENTION

According to the present disclosure it is possible to provide a glass fabric that can exhibit excellent dielectric characteristics and excellent insulating reliability, and that also allows a resin substrate with a small whitening distance to be obtained.

The disclosure further provides a prepreg, a printed circuit board, an integrated circuit and an electronic device produced using the glass fabric, as well as a method for producing the glass fabric.

### BRIEF DESCRIPTION OF DRAWINGS

Fig. 1 is a diagram showing a calibration curve for an Example.
Fig. 2 is a diagram showing a white spot for illustration in the Examples.

### DESCRIPTION OF EMBODIMENTS

An embodiment of the present disclosure (hereunder referred to as "the embodiment") will now be described. However, the invention is not limited merely to the embodiment and may incorporate various modifications without falling outside of the scope of its gist.

Throughout the present specification, in cases where multiple structures represented by the same reference numerals exist in the same formula, such structures may be independently selected and may be the same or different, unless separately specified. Even in cases where multiple structures in different formulas are represented by the same reference numerals, such structures may be independently selected and may be the same or different, unless separately specified. The measurements referred to herein were carried out based on the Examples, unless otherwise specified. The upper limits and lower limits for the stepwise numerical ranges specified herein may be replaced with upper limits or lower limits in other corresponding stepwise numerical ranges, or they may be replaced by corresponding values mentioned in the Examples.

The term "step", as used herein, refers not only to an independent step, but also includes any function added to the step, even if it cannot be clearly distinguished from another step. The scales, forms and lengths shown in the drawings are exaggerated for clarity.

### [Glass fabric]

The glass fabric of the embodiment is a glass fabric obtained by weaving glass yarn, and for example, it is a glass fabric obtained by weaving glass yarn composed of a plurality of glass filaments as warp yarn and weft yarn.

According to one aspect of the embodiment, the glass fabric is surface-treated with a surface treatment agent,
the value of the following formula A is 10 or greater:
   Formula A = Carbonyl group-derived peak height/total carbon in glass fabric, as calculated from the total carbon content in the glass fabric and the carbonyl group-derived peak height as measured by Fourier transform infrared spectroscopy, and
the number of white spots is 10/m² or less (for example, 10.0/m² or less).

According to another aspect of the embodiment, the glass fabric is surface-treated with a surface treatment agent,
the value of the following formula B is 11 or greater:
   Formula B = Carbonyl group-derived peak height/ignition loss value of the glass fabric, as calculated from the ignition loss value of the glass fabric and the carbonyl group-derived peak height as measured by Fourier transform infrared spectroscopy, and
the number of white spots is 10/m² or less (for example, 10.0/m² or less).

According to the embodiment it is possible to provide a glass fabric that allows a resin substrate (typically a printed circuit board) with a small whitening distance to be obtained, and that exhibits excellent dielectric characteristics and insulating reliability. The glass fabric of the embodiment is suitable as a material for fabrication of prepregs, printed circuit boards, integrated circuits and electronic devices.

### [Surface treatment]

The glass fabric of the embodiment is surface-treated with a surface treatment agent.

The surface-treated glass fabric has a surface treatment agent adhering to its surface. Stated differently, it may be said that adhesion of the surface treatment agent onto the surface of the glass fabric corresponds to being "surface-treated with a surface treatment agent" according to the disclosure. The concept of the "surface of the glass fabric" includes the "surface of the glass yarn composing the glass fabric".

An example of a specific mode for surface treatment, including a method of detecting the surface treatment agent, the type of surface treatment agent and the method of surface treatment, will now be described.

### [Carbonyl group-derived peak height]

A surface treatment agent with excellent radical reactivity comprises a component with a carbonyl group, such as an acryloyl or methacryloyl group. In Fourier transform infrared spectroscopy, a clear peak is detected at a characteristic location due to carbonyl groups, and therefore Fourier transform infrared spectroscopy can be used to evaluate the degree of introduction of acryloyl and methacryloyl groups into a glass fabric.

When Fourier transform infrared spectroscopy is used, the results may vary depending on the sensitivity and measurement error of the photodetector. Therefore, a calibration curve is preferably drawn based on a glass fabric that is surface-treated with a known surface treatment agent and has a known level of adhesion for the surface treatment agent. Using such a calibration curve can help improve reproducibility for the carbonyl group-derived peak height.

### [Total carbon content in glass fabric]

The total carbon content in the glass fabric is measured by a method of measuring the carbon dioxide generated when the glass fabric has been subjected to thermal decomposition, and more specifically it is measured by the method described in the Examples. Since a greater level of adhesion of the surface treatment agent onto the glass fabric tends to result in a greater total carbon content, the measuring method of the disclosure allows more convenient evaluation of the level of adhesion of the surface treatment agent onto the glass fabric.

The total carbon content in the glass fabric is preferably 0.01 to 0.8 mass%, more preferably 0.01 to 0.6 mass%, even more preferably 0.01 to 0.5 mass%, yet more preferably 0.01 to 0.4 mass% and most preferably 0.01 to 0.3 mass%, such as 0.02 to 0.20, 0.03 to 0.15 or 0.03 to 0.10. If the total carbon content is less than 0.01 mass%, the amount of surface treatment agent adhering to the glass fabric will usually be insufficient, tending to result in insulating defects. If the total carbon content in the glass fabric is greater than 0.8 mass%, the dielectric loss tangent of the glass fabric will usually be high, making it more difficult to achieve a low dielectric loss tangent for the glass fabric.

### (Relationship between carbonyl group-derived peak height and total carbon content in glass fabric)

The glass fabric of the embodiment has a value of 10 or greater for the following formula A:
Formula A = carbonyl group-derived peak height/total carbon content in glass fabric, based on the total carbon content in the glass fabric and the carbonyl group-derived peak height measured by Fourier transform infrared spectroscopy.

A value of 10 or greater for formula A corresponds to a high proportion of components with excellent reactivity (components with carbonyl groups) in the surface treatment agent adhering to the glass fabric.

One idea focused on by the present inventors concerned the "carbonyl group-derived peak height" and the "total carbon content in the glass fabric", and specifically the ratio between them (carbonyl group-derived peak height/total carbon content in glass fabric). Based on this idea which was focused on by the present inventors, the glass fabric of the invention was specified as having a high value of 10 or greater for the value of formula A.

According to this embodiment it is possible to provide a glass fabric that can yield a resin substrate with a high value for formula A and therefore a small whitening distance, and to provide a glass fabric exhibiting excellent dielectric characteristics and insulating reliability.

The value of formula A is 10 or higher (for example, 10.0 or higher), preferably higher than 10 (for example, higher than 10.0), more preferably 11 or higher (for example, 11.0 or higher), even more preferably 12 or higher (for example, 12.0 or higher), yet more preferably 13 or higher (for example, 13.0 or higher), even yet more preferably 15 or higher (for example, 15.0 or higher) and most preferably 19 or higher (for example, 19.0 or higher). If the value of formula A is 10 or higher, it will be possible to ensure adhesiveness between the glass fabric and the matrix resin, thereby allowing the whitening distance in the obtained resin substrate to be reduced. The value of formula A may also be 60 or lower (for example, 60.0 or lower).

### [Ignition loss value of glass fabric]

The ignition loss value of the glass fabric is measured by a method of heat deoiling the glass fabric (the surface-treated glass fabric), and specifically by the method described in the Examples. Since a greater level of adhesion of the surface treatment agent onto the glass fabric tends to result in a greater ignition loss value, the measuring method of the disclosure allows more convenient evaluation of the level of adhesion of the surface treatment agent onto the glass fabric.

The ignition loss value of the glass fabric is preferably 0.01 to 0.5 mass%, 0.01 to 0.4 mass% or 0.01 to 0.3 mass%, more preferably 0.02 to 0.25 mass%, even more preferably 0.03 to 0.22 mass%, yet more preferably 0.03 to 0.17 mass% and most preferably 0.04 to 0.15 mass%. If the ignition loss value is 0.01 mass% or greater it will be easier to achieve satisfactory adhesion between the resin and glass fabric in the obtained prepreg. This will help ensure heat resistance and insulating reliability of fabricated printed circuit boards. If the ignition loss value of the glass fabric is 0.5 mass% or lower, it will be easier to avoid a condition in which a surface treatment agent (or its residue) that is physically adhering to the glass fabric surface without forming chemical bonds, or a surface treatment agent (or its residue) that cannot be reduced from the glass fabric surface by water washing, and/or any modified form of the same, is present in large amounts on the glass fabric surface. This will help to obtain a low dielectric loss tangent for the glass fabric.

### (Relationship between carbonyl group-derived peak height and ignition loss value of glass fabric)

The glass fabric of the embodiment has a value of 11 or higher for the following formula B:
Formula B = carbonyl group-derived peak height/ignition loss value of the glass fabric, based on the ignition loss value of the glass fabric and the carbonyl group-derived peak height measured by Fourier transform infrared spectroscopy.

A value of 11 or higher for formula B corresponds to a high proportion of components with excellent reactivity (components with carbonyl groups) in the surface treatment agent adhering to the glass fabric.

One idea focused on by the present inventors concerned the "carbonyl group-derived peak height" and the "ignition loss value of the glass fabric", and specifically the ratio between them (carbonyl group-derived peak height/ignition loss value of the glass fabric). Based on this idea which was focused on by the present inventors, the glass fabric of the invention was specified as having a high value of 11 or higher for the value of formula B.

According to this embodiment it is possible to provide a glass fabric that can yield a resin substrate with a high value for formula B and therefore a small whitening distance, and to provide a glass fabric exhibiting excellent dielectric characteristics and insulating reliability.

The value of formula B is 11 or higher (for example, 11.0 or higher), preferably higher than 11 (for example, higher than 11.0), more preferably 12 or higher (for example, 12.0 or higher), even more preferably 13 or higher (for example, 13.0 or higher), yet more preferably 14 or higher (for example, 14.0 or higher) and most preferably 15 or higher (for example, 15.0 or higher). If the value of formula B is 11 or higher, it will be possible to ensure adhesiveness between the glass fabric and the matrix resin, thereby allowing the whitening distance in the obtained resin substrate to be reduced. The value of formula B may also be 60 or lower (for example, 60.0 or lower).

### [Dielectric loss tangent]

### (Dielectric loss tangent of glass fabric)

The glass fabric of the embodiment preferably has a dielectric loss tangent of 0.002 or lower at 10 GHz. Such a glass fabric can provide a prepreg and printed circuit board with improved dielectric characteristics. From the viewpoint of improving the dielectric characteristics, the dielectric loss tangent of the glass fabric at 10 GHz is preferably 0.0015 or lower, 0.0010 or lower, 0.0007 or lower, 0.0006 or lower, 0.0005 or lower, 0.0004 or lower, 0.0003 or lower or 0.0002 or lower. It is sufficient for the dielectric loss tangent of the glass fabric to be greater than 0.

### (Method of measuring dielectric loss tangent)

For the glass fabric of the embodiment, the dielectric loss tangent at 10 GHz is measured by a method using a split cylinder resonator (resonance-based method), and specifically by the method described in the Examples.

This method aids convenient and precise measurement, compared to conventional measuring methods in which the dielectric characteristic is evaluated by fabricating a substrate as the measuring sample. Without being limited to any particular theory, it is thought that the reason is that resonance methods are suited for evaluation in the high frequency range, and especially for evaluation of low loss materials.

Methods known for evaluating dielectric characteristics, other than resonance methods, include the lumped-constant method and reflection-transmission method. In the lumped-constant method, however, the measuring sample must be sandwiched between two electrodes to form a condenser, and this results in a more complex operation. When a low loss material is evaluated by the reflection-transmission method, the matching property of the measuring port has a major effect on measurement, and it has therefore been difficult to evaluate the dielectric loss tangent of measuring samples with high precision.

The resonance method, and specifically the method described in the Examples, therefore tends to allow more convenient and precise measurement of the dielectric loss tangent of a glass fabric.

For a glass fabric intended for use in a printed circuit board, and especially a glass fabric to be used in a printed circuit board for high-speed communication, the measuring device preferably has a prescribed range for measurement of the dielectric characteristic. For example, for measurement of the permittivity (Dk) and dielectric loss tangent (Df), the measuring device preferably has a measurable range for Dk = 1.1 Fm⁻¹ to 50 Fm⁻¹ and Df = 1.0 × 10⁻⁶ to 1.0 × 10⁻¹, more preferably it has a measurable range for Dk = 1.5 Fm⁻¹ to 10 Fm⁻¹ and Df = 1.0 × 10⁻⁵ to 5.0 × 10⁻¹, and even more preferably it has a measurable range for Dk = 2.0 Fm⁻¹ to 5 Fm⁻¹ and Df = 5.0 × 10⁻⁵ to 1.0 × 10⁻².

The measurable frequency by the measuring device for measurement of the dielectric characteristic is preferably 10 GHz or greater. A measurable frequency of 10 GHz or greater will facilitate evaluation of the properties in the frequency band range, and especially the properties in the frequency band range expected to be actually used by the glass fabric for a printed circuit board for high-speed communication.

The measurement area for the dielectric characteristic is preferably 10 mm² or greater, more preferably 15 mm² or greater and even more preferably 20 mm² or greater. This will help to increase the reliability of the measurement result, making it easier to satisfactorily judge whether or not the measurement result is within a preset reference value.

The thickness of the measuring sample is preferably 3 µm to 300 µm, more preferably 5 µm to 200 µm and even more preferably 7 µm to 150 µm.

### (Bulk dielectric loss tangent)

For a glass fabric of the embodiment, the bulk dielectric loss tangent of the glass starting material composing the glass fabric at 10 GHz is measured by a method using a split cylinder resonator (resonance method), and specifically by the method described in the Examples. The glass starting material may be glass yarn, glass filaments or glass feedstock, for example.

The bulk dielectric loss tangent at 10 GHz is preferably 0.002 or lower, more preferably 0.0015 or lower, even more preferably 0.001 or lower, yet more preferably 0.0005 or lower and most preferably 0.0004 or lower. This will aid in exhibiting the effect of the present disclosure.

### (Method of controlling dielectric loss tangent and bulk dielectric loss tangent)

The dielectric loss tangent and bulk dielectric loss tangent of the glass fabric can be controlled based on, for example:
a step of removing the degradation products and residue present on the glass surface.

Examples of degradation products and residue include the following (i) and (ii):
(i) degradation products resulting from thermal oxidation of sizing agent physically adhering to the glass surface,
(ii) residue of surface treatment agent physically adhering to the glass surface without forming chemical bonds with the glass surface, and remaining on the surface even after water washing, or modified forms of the same.

### [Glass yarn]

The glass yarn may be composed of multiple glass filaments. A glass fabric can be produced by weaving glass yarn as warp yarn and weft yarn.

### [Average filament diameter]

The average filament diameter of the glass filaments is preferably 2.5 to 9.0 µm, more preferably 2.5 to 7.5 µm, even more preferably 3.5 to 7.0 µm, yet more preferably 3.5 to 6.0 µm and most preferably 3.5 to 5.0 µm.

### [Thread count]

The thread count of the glass yarn (warp yarn and weft yarn) composing the glass fabric is preferably 10 to 120/inch (= 10 to 120/25.4 mm), more preferably 40 to 100/inch and even more preferably 40 to 100/inch.

### [Basis weight]

The basis weight of the glass fabric is preferably 8 to 250 g/m², more preferably 8 to 100 g/m², even more preferably 8 to 80 g/m² and most preferably 8 to 50 g/m².

### [Glass feedstock]

Glass fabrics used in prepregs (laminated sheets) have conventionally been glass starting materials known as E glass (non-alkaline glass). The glass fabric of the embodiment, however, may be a glass starting material such as L glass, NE glass, D glass, L2 glass, T glass, silica glass or quartz glass, for example. From the viewpoint of excellent dielectric characteristics, it is preferred to use a glass starting material such as L glass, L2 glass, silica glass or quartz glass, among which silica glass and quartz glass are especially preferred. From the viewpoint of increasing the dimensional stability of a laminated sheet comprising the glass fabric, it is preferred to use a glass starting material such as S glass, T glass, silica glass or quartz glass, with silica glass and quartz glass being especially preferred.

The silicon (Si) content of the glass yarn composing the glass fabric is preferably 95.0 to 100 mass% or 99.0 to 100 mass%, more preferably 99.5 to 100 mass% and even more preferably 99.9 to 100 mass%, in terms of silicon dioxide (SiO₂). Particularly preferred for the SiO₂ composition of the glass yarn composing the glass fabric is a range of greater than 99.9 mass%. If the Si content is 95.0 mass% or greater it will be easier to ensure the dielectric characteristic of the glass fabric and the dimensional stability of the laminated sheet. The silicon content can be determined using a known measuring technique such as atomic absorption spectrophotometry, inductively coupled plasma (ICP) or emission spectroscopy. Specifically, a calibration curve may be drawn from a reference sample of known content using an apparatus such as ICP-AES or ICP-MS, and the silicon content in the sample to be measured may be determined from the drawn calibration curve.

It has been recognized in the prior art that the hardness of glass is extremely high if the Si content is within this range, and therefore glass fabrics formed using the glass yarn are disadvantageous in terms of drillability. It has also been recognized in the prior art that resin substrates employing glass fabrics with poor drillability have longer whitening distances in the resin substrates, due to the stronger impact during drilling.

According to this embodiment, however, it is possible to provide a resin substrate with a small whitening distance even when using a glass fabric with a Si content in the range specified above.

### [Woven structure]

The woven structure of the glass fabric may be a plain weave, mat weave, satin weave or twill weave, for example, with a plain weave structure being more preferred.

### [Surface treatment agent (surface treatment solution)]

The surface treatment solution may comprise a surface treatment agent. The surface treatment for the embodiment is carried out by a method using a surface treatment solution, for example.

### (Surface treatment agent concentration)

The surface treatment solution may comprise a surface treatment agent and a mother liquor (for example, an aqueous acetic acid solution). The concentration of the surface treatment agent (for example, a silane coupling agent) in the surface treatment solution is preferably 0.1 to 2.0 mass% and more preferably 0.2 to 1.0 mass%. If the surface treatment agent concentration is within this range it will be possible to satisfactorily carry out surface treatment of the glass surface.

### (Silane coupling agent)

The surface treatment agent of the embodiment preferably comprises a silane coupling agent. That is, the glass yarn (or glass filaments) composing the glass fabric is preferably surface-treated with a silane coupling agent.

The surface treatment agent preferably comprises a silane coupling agent represented by the following formula (1):

X₃₋ₙSiYₙ (1)

(where each X may independently comprise a different organic functional group, with X composed of a functional group having a total of at least two of both a carbonyl group and an unsaturated carbon double bond, each Y is independently an alkoxy group, and n is an integer of 1 to 3).

In regard to X, the unsaturated carbon double bond is preferably a bond derived from either or both an acryloyl and methacryloyl group, from the viewpoint of helping to increase adhesiveness between the glass fabric and matrix resin, and from the viewpoint of helping to reduce the whitening distance in the resin substrate. An especially preferred mode for the unsaturated carbon double bond is a bond derived from a methacryloyl group.

For Y, the alkoxy group is preferably an alkoxy group of 1 to 5 carbon atoms (1, 2, 3, 4 or 5 carbon atoms), from the viewpoint of stability during surface treatment of the glass fabric.

The silane coupling agent used in the surface treatment agent may be a silane coupling agent represented by formula (1), either alone or as a combination of multiple different types. For example, two or more different silane coupling agents with different X values may be used in admixture.

Examples of silane coupling agents represented by general formula (1) include:
2-propenoic acid, 2-methyl-, (dimethoxysilylene)bis(oxy-2,1-ethanediyl)ester,
2-propenoic acid, 2-methyl-, 1-[(trimethoxysilyl)methyl]-1,2-ethanediyl ester,
2-propenoic acid, 2-methyl-, 2-[(trimethoxysilyl)methyl]-1,3-propanediyl ester,
1,1'-[2-[3-(trimethoxysilyl)propoxy]-1,3-propanediyl] bis(2-methyl-2-propenoate),
1,1'-[2-[[(2-methyl-1-oxo-2-propen-1-yl)oxy]methyl]-2-[[3-(triethoxysilyl)propoxy]methyl]-1,3-propanediyl] bis(2-methyl-2-propenoate),
1-[2-[(2-methyl-1-oxo-2-propen-1-yl)oxy]-1-[[(2-methyl-1-oxo-2-propen-1-yl)oxy]methyl]ethyl]
2-[3-(triethoxysilyl)propyl]butane dioate,
9,9-diethoxy-2-[[2-[(2-methyl-1-oxo-2-propen-1-yl)oxy]ethoxy]methyl]-4-oxo-3,10-dioxa-5-aza-9-siladodec-1-yl 2-methyl-2-propenoate,
1,1'-[2-[[(2-methyl-1-oxo-2-propen-1-yl)oxy]methyl]-2-[6-(trimethoxysilyl)hexyl]-1,3-propanediyl] bis(2-methyl-2-propenoate),
acrylic acid, [[2-[(trimethoxysilyl)methoxy]ethyl]imino]diethylene ester,
2-propenoic acid, 1,1'-[2-(8,8-dimethoxy-3-oxo-2,9-dioxa-6-thia-8-siladec-1-yl)-2-[[(1-oxo-2-propen-1-yl)oxy]methyl]-1,3-propanediyl] ester, and
1,1'-[2-methyl-2-[[[[3-(trimethoxysilyl)propyl]amino]carbonyl]amino]-1,3-propanediyl] di-2-propenoate,
1,1'-[2-[[2-(9,9-dimethoxy-4-oxo-3,10-dioxa-5-aza-9-silaundec-1-yl)-11,11-dimethoxy-1,6-dioxo-5,12-dioxa-2,7-diaza-11-silatridec-1-yl]amino]-2-methyl-1,3-propanediyl] di-2-propenoate.

The silane coupling agent used may adjusted as appropriate depending on the dielectric loss tangent of the glass fabric before surface treatment and the matrix resin used in the resin substrate. Naturally, the silane coupling agent represented by formula (1) may be used together with a silane coupling agent other than one represented by formula (1).

It is preferred, however, to use two or more silane coupling agents represented by formula (1) above which have different molecular weights. Using two or more silane coupling agents with different molecular weights will tend to increase the treatment agent density on the glass surface, resulting in even greater reactivity with the matrix resin.

### (Molecular weight)

The molecular weight of the surface treatment agent (for example, the molecular weight of the silane coupling agent), is preferably 200 to 900, more preferably 230 to 800, even more preferably 260 to 700 and most preferably 300 to 600. If the molecular weight is 900 or lower, the dispersibility in water will tend to be satisfactory, thus helping to prevent generation of white spots in the glass fabric.

When two or more different surface treatment agents (for example, silane coupling agents) are used, the weighted average value of the molecular weight based on the mass of each surface treatment agent is preferably within the range specified above, and more preferably all of the molecular weights of the surface treatment agents used are within the range specified above. For example, when surface treatment agents are prepared to 0.5 mass% and 1.0 mass% for silane coupling agents having molecular weights of 300 and 500, the weighted average value is calculated by the following formula: $Weighted average value = \left\{\left(300\times 0.5\right)/\left(0.5+1.0\right)\right\} + \left\{\left(500\times 1.0\right)/\left(0.5+1.0\right)\right\} = 433$ (omitting trailing decimal places for convenience of illustration).

### [Average degree of opening of glass fabric]

The average degree of opening of the glass fabric may be 35% or greater, for example, and is preferably greater than 40%, more preferably greater than 43%, even more preferably greater than 46%, greater than 50%, greater than 53%, greater than 56% or greater than 60%, and most preferably greater than 65%. If the average degree of opening of the glass fabric is 35% or greater, or greater than 40%, it will be easier to prevent residue of air bubbles (voids) in the glass yarn bundle when the resin substrate is fabricated, thus helping to prevent adverse effects on the soldering heat resistance or insulating reliability.

Since the silane coupling agent represented by formula (1) has relatively strong intermolecular forces and is thus more active, the impregnating property of the matrix resin in the glass fabric tends to be less advantageous than a silane coupling agent that is not represented by formula (1). Consequently, a glass fabric that has been surface-treated with a silane coupling agent represented by formula (1) preferably has an average degree of opening of 35% or greater, or greater than 40%, from the viewpoint of adequately obtaining an effect of improving the insulating reliability.

### [White spots on glass fabric]

A surface-treated glass fabric will sometimes be found to have an outer appearance with white spots. Such white spots tend to repel from the matrix resin used for prepreg fabrication, and can thus cause defects in outer appearance of the obtained prepreg, resulting in poor soldering heat resistance and insulating reliability of the obtained resin substrate.

The cause of such white spots has been considered unknown in the prior art.

However, the present inventors have demonstrated that one cause of white spots is aggregates or modified aggregates of the surface treatment agent (for example, the silane coupling agent).

In particular, the present inventors have shown that the silane coupling agent represented by formula (1), having a relatively high molecular weight and relatively strong hydrophobicity, tends to generate aggregates, and that when the solvent in the surface treatment solution comprises water, the frequency of white spot generation in the surface-treated glass fabric tends to increase (with a frequency of 10.0/m² or greater, for example).

In order to minimize white spots, suitable methods include:
mixing the surface treatment solution in a specific manner,
carrying out temperature control and pH control of the surface treatment solution, and
filtering the surface treatment solution to remove the aggregates in the surface treatment solution.

The frequency of white spot generation in the glass fabric is preferably 7.0/m² or lower, more preferably 4.0/m² or lower, even more preferably 2.0/m² or lower or 0.1/m² or lower, and most preferably 0.05/m² or lower. This will help to obtain a prepreg with an excellent outer appearance. The frequency of white spots is theoretically greater than 0.

### [Method for producing glass fabric]

One aspect of the embodiment is a method for producing the glass fabric of the embodiment.

The production method of the embodiment has:
a surface treatment step in which the glass yarn is treated using a surface treatment solution containing a surface treatment agent with a molecular weight of 200 or higher,
wherein the surface treatment step comprises at least one of the following steps:
   a step of adding a solvent to the surface treatment agent to adjust the surface treatment solution;
   a step of adjusting the temperature of the surface treatment solution;
   a step of adjusting the pH of the surface treatment solution; and
   a step of filtering the surface treatment solution.

The production method of the embodiment may also optionally comprise the following steps:
a step of heating glass yarn to reduce the amount of fiber sizing agent adhering to the glass yarn (heat deoiling step),
a step of washing the glass yarn (washing step), and/or
a step of opening the glass filament (opening filament step).

One or more from among the surface treatment step, opening filament step and washing step may be carried out on the glass yarn before the step of weaving the glass yarn to obtain a glass fabric (weaving step), or any of the steps may be carried out on the glass fabric after the weaving step. The order of the heat deoiling step, surface treatment step, opening filament step and washing step may also be changed. When a washing step is carried out after the weaving step, high-pressure water spraying may be used for the washing step, so as to simultaneously carry out the opening filament step. The composition of the glass fabric will generally not change before and after opening.

### [Heat deoiling step]

Heating the glass yarn in this step can reduce, and preferably remove, the fiber sizing agent and its residue, or their modified forms, which may be adhering onto the glass yarn. By carrying out a heat deoiling step it is possible to form a surface treatment layer on the surface of glass yarn (glass filaments) while reducing organic materials that can potentially increase the dielectric loss tangent, thus facilitating formation of a glass fabric with an excellent dielectric characteristic. The means for heat deoiling may be any known means (such as heating means, a heating medium, a heating mechanism, a heating apparatus or a heating part).

One known mode for the heat deoiling step is a method of heating the glass fabric at a temperature of 600 to 1600°C.

If a glass fabric greige with a glass yarn softening point of 900°C or higher is heated in a temperature range of 600 to 1600°C in the heat treatment step, it will be easier to minimize damage to the glass fabric and to reduce the dielectric loss tangent of the glass fabric. From the viewpoint of satisfactorily obtaining the effect of the disclosure, the heat deoiling temperature is preferably 700 to 1500°C, more preferably 800 to 1400°C, even more preferably 900 to 1300°C and most preferably 1000 to 1200°C. If the heat deoiling temperature is 600°C or higher it will be easier to effectively remove sizing agent adhering to the glass fabric greige, thus facilitating formation of a glass fabric with an excellent dielectric characteristic. If the heat deoiling temperature 1600°C or lower, it will be easier to inhibit devitrification of the glass, thus helping to prevent reduction in the strength of the glass fabric.

The heating time is preferably 30 minutes or less, more preferably 15 minutes or less, even more preferably 5 minutes or less and especially preferably 90 seconds or less. Because the heat treatment is carried out at high temperature, a heating time of 30 minutes or less will tend to reduce damage to the glass fabric, thus helping to avoid problems such as partial opening of holes in the glass fabric during working, or cutting of the glass fabric. The heating time may be 1 second or longer, 5 seconds or longer, 10 seconds or longer or 15 seconds or longer, for example, from the viewpoint of effectively removing the sizing agent.

When heat deoiling of the glass fabric is carried out in a closed system, the glass fabric is preferably placed in a heating furnace from the viewpoint of achieving suitable heating with the heating means. From the viewpoint of storage space, and a more efficient heating range, the glass fabric is preferably heated while stored as a roll. From the viewpoint of increasing efficiency for removal of organic matter and the viewpoint of shortening the removal time for organic matter, the heating is preferably carried out while conveying the glass fabric in the heating furnace. The glass fabric may be conveyed by a combination of an unwinding mechanism and a winding mechanism, for example.

When heat deoiling of the glass fabric is carried out in an open system, heating is preferably carried out while the glass fabric is conveyed, from the viewpoint of ensuring the area to be heated. The glass fabric may be conveyed by a combination of an unwinding mechanism and a winding mechanism, for example.

The mode used for the heat deoiling step is not limited to the one described above.

Another example for the heat deoiling step is:
a method of heating under conditions such that the degree of heating is 450 (°C·h) or higher, as represented by: heating temperature (°C) of 100°C or higher (but with a maximum heating temperature of 100 to 600°C) × heating time (h), in a vacuum or in a gas with a dew point of 15°C or lower.

### (Heating means)

The heating means may be, for example, a heating furnace, electric heater or burner, with a gas-operated single radiant tube burner or electric heater being preferred. Multiple different heating means may also be combined.

From the viewpoint of efficiently removing organic matter adhering to the glass fabric surface, a continuous system in which the glass fabric is heated while continuously passing it through a heating furnace, is preferred over a batch system in which the glass fabric wound around a winding core is heated at a specified ambient temperature. More preferred is a system that employs washing water with a low metal ion content, such as reverse osmosis (RO) water or ion-exchanged water, and that allows continuous washing of the glass fabric.

From the viewpoint of low running cost, the heating means may be heating the glass fabric by contacting the glass fabric with a member (contact member) that has been heated to a specified temperature.

The contact member may be any one that can heat the glass fabric at high temperature. The shape of the contact member is preferably a roll shape for easier conveyance of the glass fabric. Specifically, the contact member is preferably, for example, a roll that can be used in a high-temperature range and that is heated with an induction heating system with relatively low variation in temperature in the widthwise direction. When the glass fabric is heated with a contact member, the temperature of the contact member and the surface temperature of the glass fabric may be approximately equal.

For continuous heating of the glass fabric, the system using the roll is preferably one comprising a mechanism for removal of adhering contaminants, such as a blade, in order to remove carbides adhering to the roll.

### (Steam application means)

The means for application to the glass fabric (steam application means) may be spraying, shower diffusion or a jet nozzle application. The gas discharged from the heating furnace may optionally be reutilized as high-temperature steam.

The steam applied to the glass fabric may comprise a volatile solvent, steam, or a gas other than steam, for example, but it is preferably steam from the viewpoint of minimizing toxicity to the human body and from the viewpoint of facilitating decomposition of the sizing agent used in the glass fibers. The temperature of the high-temperature steam may be a temperature such that the surface temperature of the glass fabric is higher than 650°C, in which case a method allowing the high-temperature steam and heated air to be supplied in any desired proportion may be employed as necessary. The temperature of the high-temperature steam may be 400°C or higher, 450°C or higher, 550°C or higher, 600°C or higher or 650°C or higher.

### [Surface treatment step]

In the surface treatment step, a surface treatment solution comprising a surface treatment agent with a molecular weight of 200 or higher is used for treatment of the glass yarn.

The method of treating the glass yarn with the surface treatment solution (for example, a method of coating the surface treatment solution onto the glass yarn) may be:
(a) a method of conveying the glass fabric while dipping it into the surface treatment solution which is stored in a bath (hereunder referred to as "dipping method"), or
(b) a method of directly coating the surface treatment solution onto the glass fabric using a roll coater, die coater or gravure coater. When a dipping method is employed, the time for immersion of the glass fabric in the surface treatment solution is preferably selected to be between 0.5 seconds and 1 minute.

In the surface treatment step of the method of this embodiment, a surface treatment agent with a molecular weight of 200 or higher, and particularly a silane coupling agent represented by formula (1), is used for surface treatment of the glass yarn. The silane coupling agent to be used in the method of the embodiment is one having a higher molecular weight and thus more powerful hydrophobicity than most silane coupling agents.

As mentioned above, it has been demonstrated by the present inventors that when the solvent in the surface treatment solution comprises water, this tends to produce aggregates of the surface treatment agent, and additionally that when the solvent in the surface treatment solution comprises water, the frequency of white spot generation in the glass fabric after surface treatment also tends to increase.

The present inventors have found that, for a surface treatment solution using a surface treatment agent with a molecular weight of 200 or greater, and especially a silane coupling agent represented by formula (1), it is possible to examine white spots on glass fabrics by carrying out the following measures (A) to (C), for example.
(A) Addition of a solvent (for example, a weakly acidic solution as the mother liquor) to the surface treatment agent in trace amounts at a time,
(B) control of the temperature and/or pH of the surface treatment solution during surface treatment,
(C) filtration of the surface treatment solution during surface treatment.

### (A) Preparation of surface treatment solution

Since common silane coupling agents have excellent compatibility with water and excellent dispersibility in water, they are prepared by adding small amounts of silane coupling agent into weakly acidic water with a pH of about 3 to 5 while stirring.

In the method of this embodiment, however, a small amount of a surfactant and a solvent (for example, an aqueous acetic acid solution with a concentration of 60%) may be added to the diluted solution obtained by diluting the surface treatment agent with a small amount of methanol, to obtain a pre-solution of the surface treatment agent. The solvent in the pre-solution is preferably added for hydrolysis of the alkoxide groups of the silane coupling agent, preferably with the amount of solvent added being adjusted according to the desired degree of hydrolysis. An aqueous solution prepared to pH 3 to 4 (also referred to herein as "mother liquor") may also be added to the pre-solution in small portions at a time while stirring, to allow uniform dispersion of the surface treatment agent in the aqueous solution. This will help prevent aggregates from forming in the surface treatment solution.

The surfactant used may be a nonionic surfactant, anionic surfactant, cationic surfactant or amphoteric surfactant, and the composition and amount may be changed as appropriate depending on the type and amount of surface treatment agent. A different type of surfactant may also be used in combination.

The amount of surfactant is preferably 0.2 to 10 mass%, more preferably 0.4 to 9 mass%, even more preferably 0.6 to 8 mass% and most preferably 1 to 6 mass%, with respect to the surface treatment agent (for example, a silane coupling agent). If the amount of surfactant satisfies this range it will be easier to uniformly disperse the silane coupling agent.

Nonionic surfactants include glycerin fatty acid esters, sorbitan fatty acid esters, sucrose fatty acid esters, polyoxyethylene alkyl ethers, polyoxyethylene alkylphenyl ethers, polyoxyethylene polyoxypropylene glycols, polyethylene glycol fatty acid esters, polyoxyethylene sorbitan fatty acid esters and fatty acid alkanolamides.

Anionic surfactants include fatty acid monocarboxylic acid salts, polyoxyethylene alkyl ether carboxylic acid salts, N-acylsarcosine salts, N-acyl glutamates, dialkylsulfosuccinic acid salts, alkane sulfonates, alpha-olefin sulfonates, straight-chain alkyl benzenesulfonates, alkyl benzenesulfonates, naphthalene sulfonate-formaldehyde condensates, alkylnaphthalene sulfonates, N-methyl-N-acyltaurine salts, alkyl sulfates, polyoxyethylene alkyl ether sulfates, sulfuric acid ester salts of fats and oils, alkyl phosphates, polyoxyethylene alkyl ether phosphates and polyoxyethylene alkylphenyl ether phosphates.

Cationic surfactants include monoalkylamine salts, dialkylamine salts, trialkylamine salts, alkyltrimethylammonium chlorides and alkylbenzalkonium chlorides.

Amphoteric surfactants include 2-alkyl-N-carboxymethyl-N-hydroxyethyl imidazolinium betaine, alkyl betaines, fatty acid amidopropyl betaine, alkyldiethylenetriaminoacetic acids and alkylamine oxides.

### (B) Temperature control and/or pH control of surface treatment solution

From the viewpoint of reducing aggregates in the surface treatment solution, the temperature of the surface treatment solution while carrying out surface treatment is preferably controlled to 10 to 30°C, more preferably controlled to 13 to 27°C, even more preferably controlled to 15 to 25°C and most preferably controlled to 17 to 23°C.

While carrying out surface treatment, the pH of the surface treatment solution may vary depending on impurities such as alkali metals present in trace amounts in the glass fabric. From the viewpoint of reducing aggregates in the surface treatment solution, the range of variation in the pH of the surface treatment solution is preferably small. While carrying out the surface treatment, the pH of the surface treatment solution is preferably controlled to 2.5 to 5.5, more preferably controlled to 2.8 to 5.2 and even more preferably controlled to 3.0 to 5.0. The method of controlling the pH to within the predetermined range may be, for example, a method of bubbling the carbon dioxide through the surface treatment solution.

Either or both temperature control of the surface treatment solution and pH control of the surface treatment solution may be carried out. From the viewpoint of satisfactorily inhibiting aggregates in the surface treatment solution, it is preferred both to control the temperature of the surface treatment solution and to control the pH of the surface treatment solution.

The phrase "control the temperature of the surface treatment solution" includes not only a procedure of raising and/or lowering the temperature of the surface treatment solution, but also a procedure of holding the temperature of the surface treatment solution at a predetermined value, and a procedure of detecting the temperature in order to confirm whether or not the temperature of the surface treatment solution is within a predetermined range.

The phrase "control the pH of the surface treatment solution" includes not only a procedure of raising and/or lowering the pH of the surface treatment solution, but also a procedure of holding the pH of the surface treatment solution at a predetermined value, and a procedure of detecting the pH in order to confirm whether or not the pH of the surface treatment solution is within a predetermined range.

### (C) Filtration of surface treatment solution

From the viewpoint of reliably collecting aggregates in the surface treatment solution, the surface treatment solution is preferably filtered while carrying out the surface treatment. The aggregates that may be generated in the surface treatment solution are preferably collected by filtration while circulating the surface treatment solution.

Filtration is preferably carried out in multiple stages from the viewpoint of increasing the collection efficiency for aggregates. For example, preferably the surface treatment solution is subjected to two-stage filtration in which the aggregates are removed in a first stage with a relatively coarse filter, and then re-filtered with a finer filter than the primary filter. Such multistage filtration can help prevent blocking of the filter, thus tending to avoid interruption during the fabrication process for the glass fabric.

### (Drying step)

The surface treatment step may further comprise:
a step of coating the surface treatment solution onto the glass yarn and then drying the solvent in the surface treatment solution (drying step).

In the drying step, the surface treatment agent becomes easily anchored to the surface of the glass yarn (the surfaces of the glass filaments), and in particular the surface treatment agent becomes easily anchored to the surface of each individual glass yarn (the surface of each individual glass filament). The method of drying the solvent may be a known method, such as a method of drying by heating, and specifically a method of drying by heating with hot air or electromagnetic waves.

The drying temperature is preferably 80°C or higher and more preferably 90°C or higher from the viewpoint of adequate reaction between the surface treatment agent and glass. The drying temperature is also preferably 300°C or lower and more preferably 180°C or lower from the viewpoint of preventing degradation of the organic functional groups of the surface treatment agent.

### [Opening filament step]

The production method of the embodiment preferably has an opening filament step after the surface treatment step. The opening filament method in the opening filament step may be, for example, a method of opening the glass fabric with spray water (high-pressure water opening), a Vibrowasher, ultrasonic water or a mangle. Lowering the tension applied to the glass fabric during opening filament makes it easier to widen the width of the glass yarn and to achieve some degree of removal of the surface treatment agent that has not chemically bonded to the glass surface. In order to help prevent reduction in the tensile strength of the glass fabric caused by opening, it is preferred to carry out measures for reducing friction of contact members, and for optimization and high coverage of the sizing agent, during weaving of the glass yarn.

In the opening filament step, a plurality of opening filament methods are preferably used to open the glass fiber bundles. This will facilitate control of the average degree of opening of the glass fabric to the specified range even if the glass fabric tends to have poor impregnability for the matrix resin.

### [Washing step]

The washing step (finishing washing step) may be any method that can reduce residue of the surface treatment agent or its modified forms, which have not formed chemical bonds on the glass filament surfaces, and for example, it may be a method of washing the glass yarn with an organic solvent. Carrying out a washing step will aid in adjusting the difference between the dielectric loss tangent and bulk dielectric loss tangent to within the prescribed range for the obtained glass fabric, even when using a glass starting material with a high silicon (Si) content, such as quartz glass.

The washing step is preferably carried out with a highly hydrophobic organic solvent in order to reduce the amount of residue, which is difficult to reduce with water, and it is preferably carried out by washing with an organic solvent having high affinity with the hydroxyl group-containing silane coupling agent residue.

The washing method may be a known method such as, for example, dipping or shower spraying, and if necessary the washing may be carried out while heating or cooling. In order to avoid reattachment of the dissolved accretions on the glass fabric, the excess solvent in the washed glass fabric is preferably reduced with a squeezing roller before finishing and drying. Examples of suitable organic solvents with high hydrophobicity include:
saturated straight-chain aliphatic hydrocarbons such as *n*-pentane, *i*-pentane, *n*-hexane, *i*-hexane, *n*-heptane, *i*-heptane, *n*-octane, *i*-octane, 2,2,4-trimethylpentane (isooctane), *n*-nonane, *i*-nonane, *n*-decane, *i*-decane and 2,2,4,6,6-pentamethylheptane (isododecane);
saturated cyclic aliphatic hydrocarbons such as cyclopentane, cyclohexane, methylcyclohexane, dimethylcyclohexane and ethylcyclohexane;
aromatic hydrocarbons such as benzene, toluene, xylene, ethylbenzene, diethylbenzene, trimethylbenzene and triethylbenzene; and
halogen solvents such as chloroform, dichloromethane and dichloroethane.

Organic solvents with high affinity for modified forms of surface treatment agents (such as silane coupling agents) include:
alcohols such as methanol, ethanol and butanol;
ketones such as acetone and methyl ethyl ketone;
ethers such as methyl ethyl ether and diethyl ether;
amides such as N,N-dimethylformamide and N,N-dimethylacetamide; and
dimethyl sulfoxide.

Preferred among these are aromatic hydrocarbons, alcohols and ketones, with methanol or toluene being more preferred, from the viewpoint of facilitating adjustment of the difference between the dielectric loss tangent and bulk dielectric loss tangent of the obtained glass fabric within the specified range.

The production method of the embodiment preferably comprises a step of drying the washed glass fabric (a post-washing drying step), in order to reduce the organic solvent after washing, and from the viewpoint of facilitating reduction in the organic solvent by drying, the organic solvent used for washing preferably has a boiling point of no higher than 120°C. A known method such as heat drying or blast drying may be used for drying of the organic solvent.

When heat drying is carried out to reduce organic solvent in the post-washing drying step, hot air drying is preferred using low-pressure steam or heat transfer oil as the heat source, from the viewpoint of safety. The drying temperature is preferably at or above the boiling point of the washing solvent, and it is preferably no higher than 180°C from the viewpoint of inhibiting deterioration of the silane coupling agent.

### [Optional steps]

The production method of the embodiment may also comprise other optional steps in addition to those described above.

Other steps include, for example, a step of working the glass fabric into a slit shape (slitting step).

### (Examining step or measuring step)

Other steps include either or both of the following steps:
a step of examining white spots in the glass fabric; and
a step of measuring the carbonyl group-derived peak height for the glass fabric by Fourier transform infrared spectroscopy.

The production method of the embodiment comprising the steps described above facilitates formation of a glass fabric of the embodiment.

### [Test methods]

Another aspect of the embodiment is a test method for a glass fabric obtained by weaving glass yarn.

The test glass fabric is surface-treated with a surface treatment agent, and
the test method comprises a step of examining white spots in the glass fabric based on the carbonyl group-derived peak height for the glass fabric and the total carbon content in the glass fabric or the ignition loss value of the glass fabric.

For the test method of this embodiment, the test glass fabric, the carbonyl group-derived peak height, the total carbon content, the ignition loss value and the white spots are the same as described under [Glass fabric] above. The test method of this embodiment allows evaluation of the properties of a glass fabric based on white spots, which have been the focus of the present inventors.

### [Prepreg]

A prepreg of the embodiment comprises a glass fabric, a matrix resin and an inorganic filler. The prepreg of the embodiment may be obtained using the glass fabric of the embodiment as the glass fabric. This provides a prepreg with excellent properties (for example, a prepreg with few voids).

The matrix resin used may be a thermosetting resin or a thermoplastic resin. A thermosetting resin and a thermoplastic resin may also be used in combination.

Examples of thermosetting resins include:
a) epoxy resins obtained by reacting a compound with an epoxy group and a compound with at least one group such as an amino, phenol, acid anhydride, hydrazide, isocyanate, cyanate or hydroxyl group that reacts with the epoxy group, without a catalyst, or reacting them with addition of a catalyst having reaction catalyzing activity, such as an imidazole compound, tertiary amine compound, urea compound or phosphorus compound, and curing the reaction product;
b) radical polymerization-type curing resins obtained by using a compound with at least one allyl, methacryl or acrylic group, and using a thermal decomposition-type catalyst or photodecomposition-type catalyst as a reaction initiator, and curing;
c) maleimide triazine resins obtained by reacting and curing a compound with a cyanate group and a compound with a maleimide group;
d) thermosetting polyimide resins obtained by reacting and curing a maleimide compound and an amine compound; and
e) benzoxazine resins obtained by crosslinked curing of a compound with a benzoxazine ring by thermal polymerization.

Examples of thermoplastic resins include polyphenylene ether, modified polyphenylene ether, polyphenylene sulfide, polysulfone, polyethersulfone, polyallylate, aromatic polyamides, polyether ether ketone, thermoplastic polyimides, insoluble polyimides, polyamideimide, LCP, polyesters and fluorine resins.

For satisfactory reactivity of acryloyl or methacryloyl groups, it is preferred to use either or both polyphenylene ether and modified polyphenylene ether as the matrix resin.

The prepreg may also comprise an inorganic filler. Examples of inorganic fillers include aluminum hydroxide, zirconium oxide, calcium carbonate, alumina, mica, aluminum carbonate, magnesium silicate, aluminum silicate, silica, talc, staple glass fibers, aluminum borate and silicon carbide. The inorganic filler may also be used together with a thermosetting resin.

### [Printed circuit board]

The printed circuit board of the embodiment comprises a prepreg. In particular, the printed circuit board of the embodiment comprises the prepreg of the embodiment as a prepreg. This provides a printed circuit board with excellent properties (for example, a printed circuit board with excellent insulating reliability).

### [Integrated circuit and electronic device]

An integrated circuit of the embodiment comprises a printed circuit board according to the embodiment. An electronic device of the embodiment also comprises a printed circuit board according to the embodiment. An integrated circuit or electronic device with excellent properties can thus be provided.

### EXAMPLES

The embodiment will now be explained using Examples and Comparative Examples. However, it is to be understood that the embodiment is not limited only to these Examples. Production, measurement and evaluation in the Examples and Comparative Examples were carried out by the following methods.

### [Thickness]

A micrometer was used according to JIS R 3420 7.10, carefully rotating the spindle for gentle contact parallel to the measuring surface, and reading off the scale after the ratchet tapped three times. JIS R 3420 specifies general test methods for products such as glass long fibers and glass fabrics employing glass long fibers.

### [Basis weight]

The glass fabric was cut to a specified size to obtain a sample. The weight of the sample was divided by the sample area to determine the basis weight. The glass fabric was cut to a size of 10 cm × 10 cm to obtain a sample, and the weight was measured to calculate the basis weight (g/m²).

### [Equivalent thickness]

Since a glass fabric is a discontinuous surface composed of air and glass, the basis weight of each glass fabric was divided by the glass density to calculate the equivalent thickness necessary for measurement by resonance. The formula for calculation is as follows: $Equivalent thickness \left(μm\right) = basis weight \left(g/{m}^{2}\right) / glass density \left(g/{cm}^{3}\right) .$

### [Dielectric loss tangent]

The dielectric loss tangent of each glass fabric was measured according to IEC 62562. Specifically, a glass fabric sample taken at the size necessary for measurement with each split cylinder resonator was stored for 8 hours in a constant temperature and humidity oven at 23°C, 50% RH for humidification. Next, a split cylinder resonator (product of EM Lab) and an impedance analyzer (product of Agilent Technologies) were used to measure the dielectric characteristic at 10 GHz. The measurement was conducted 5 times for each sample, and the average value was calculated. The thickness of each sample was recorded as the equivalent thickness. Incidentally, IEC 62562 specifies a method of measuring dielectric characteristics in the microwave band, of fine ceramic materials for dielectric substrates used primarily in microwave circuits.

A 300 µm-thick glass plate was prepared having the same type and same composition as each glass fabric that had been measured for dielectric loss tangent. The thickness obtained by measurement of the glass plate thickness was used in measurement of the bulk dielectric loss tangent at 10 GHz, by the same method as for measurement of the dielectric loss tangent.

### [Ignition loss value]

The ignition loss value of the glass fabric was determined according to JIS R3420. Specifically, the glass fabric was dried under conditions with a temperature of 110°C ±5°C for a period of 60 minutes. It was then transferred to a desiccator and allowed to cool at room temperature for 20 minutes, after which the mass of the test piece was measured up to 0.1 mg units (A mg). The dried test piece was subjected to heat treated under conditions with a temperature of 625°C ±20°C for a period of 20 minutes. It was then transferred to a desiccator and allowed to cool for 20 minutes, after which the mass of the test piece was measured up to 0.1 mg units (B mg). The ignition loss value was calculated by the following formula, and rounded to three decimal places. $Ignition loss value \left(%\right) = \left[\left\{A\left(mg\right)-B\left(mg\right)\right\}/A\left(mg\right)\right] \times 100$

### [Average degree of opening]

The opening degree of the warp yarn of the glass fabric was calculated by the following formula: 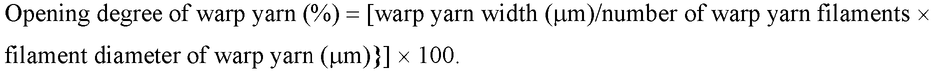 Opening degree of warp yarn (%) = [warp yarn width (µm)/number of warp yarn filaments × filament diameter of warp yarn (µm)}] × 100.

The opening degree of the weft yarn of the glass fabric was calculated by the following formula: 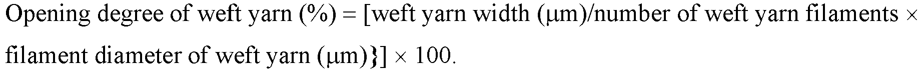 Opening degree of weft yarn (%) = [weft yarn width (µm)/number of weft yarn filaments × filament diameter of weft yarn (µm)}] × 100.

The calculated opening degree (%) of the warp yarn and opening degree (%) of the weft yarn were used to calculate the average degree of opening by the following formula: 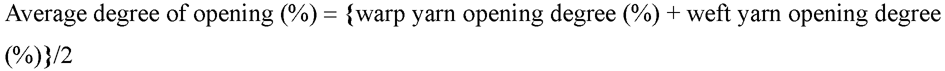 Average degree of opening (%) = {warp yarn opening degree (%) + weft yarn opening degree (%)}/2

### (Number of filaments of warp yarn and weft yarn, and filament diameter)

For calculation of the average degree of opening, the numbers of filaments in the warp yarn and weft yarn were determined by observing a cross-sectional image of the glass yarn. Specifically, a cross-sectional image of the glass yarn was taken as the warp yarn (or weft yarn), and the number of warp yarn (or weft yarn) filaments in the cross-sectional image, and the filament diameter, were measured.

Image acquisition of the glass yarn and measurement of the number of filaments were repeated in the same manner, and the average value for five obtained measurements was used as the number of filaments of the warp yarn (or weft yarn), and the filament diameter.

### (Warp yarn width and weft yarn width)

For calculation of the average degree of opening, the warp yarn width and weft yarn width were determined by the following method .

First, five glass fabric test pieces with sizes of 70 mm in the warp direction and 70 mm in the weft direction were cut out from the glass fabric.

Each cut out test piece was observed using a macroscope from the vertical direction at 100x magnification. The widths of 250 warp yarns (or weft yarns) were measured randomly for each test strip, and the average value for the widths of the 250 warp yarns (or weft yarns) was calculated. The calculated average value was used as the warp yarn width (or weft yarn width).

### [Total carbon content]

The glass fabric was cut into a quadrilateral shape with a mass of about 80 mg. The cut out glass fabric was heated at about 800°C for 1 minute, and the amount of carbon dioxide in the generated gas was measured by gas chromatography to determine the amount of carbon dioxide in the generated gas. Also, acetanilide (C₈H₉NO) having a specified mass W (mg) was heated at about 800°C for 1 minute, and the amount of carbon dioxide generated was determined.

A SUMIGRAPH NC-TR22 (product of Sumika Chemical Analysis Service, Ltd.) was used for measurement of the carbon dioxide amount. The molecular weight and carbon percentage used for acetanilide were as follows:
acetanilide molecular weight = 135.17
acetanilide carbon percentage = 71.09%.

The total carbon content per mass of the glass fabric was calculated based on the following formula: 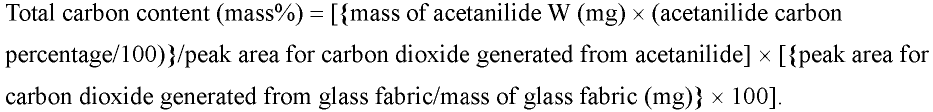 Total carbon content (mass%) = [{mass of acetanilide W (mg) × (acetanilide carbon percentage/100)}/peak area for carbon dioxide generated from acetanilide] × [{peak area for carbon dioxide generated from glass fabric/mass of glass fabric (mg)} × 100].

The total carbon content was measured for each of a total of 10 different samples with different cutting locations of the glass fabric, and the average value was recorded as the total carbon content.

### [Fabrication of heat fabric]

A heat fabric with the surface treatment agent removed was obtained by the following procedures 1 to 3:
Procedure 1: A glass fabric was heated and deoiled at 615°C for 1 hour.
Procedure 2: The ignition loss value of the glass fabric obtained by procedure 1 was measured.
Procedure 3: If the ignition loss value obtained by Procedure 2 was higher than 0.01 mass%, then

Procedure 1 was repeated (procedure 1 and 2 were repeated until the ignition loss value obtained by procedure 2 fell to 0.01 mass% or lower).

### [Peak height for carbonyl groups]

The glass fabric and the heat fabric obtained by the method described above were used to determine the peak height for carbonyl groups in the surface treatment agent adhering to the glass fabric, by Fourier transform infrared spectroscopy. The measuring apparatus and measuring method were as follows.
(Measuring apparatus: Fourier transform infrared spectrophotometer (FT-IR))
Model: Variant 670-IR by Agilent Technologies
Measurement: Transmission method
Number of scans: 64
Wavenumber resolution: 4 cm⁻¹
Measuring wavenumber: 400 cm⁻¹ to 4000 cm⁻¹

### (Measuring method)

(1) The variant 670-IR was calibrated and prepared for measurement by the transmission method.
(2) Four heat fabrics were stacked and used as a sample, and the sample was fixed to the holder. After setting on the sample stage in the apparatus, the infrared spectrum of the heat fabric was measured by the transmission method.
(3) Four glass fabrics were stacked and used as a sample, and the infrared spectrum of the glass fabric was measured by the transmission method, using the same procedure as (2) above.
(4) The difference spectrum for the infrared spectrum was determined from the results of (2) and (3) above.
(5) The heights of the carbonyl group-derived peaks in the range of 1600 cm⁻¹ to 1900 cm⁻¹ were determined from the difference spectrum obtained in (4) above. The carbonyl group-derived peak height was divided by the number of stacked glass fabrics (four, in this example), to determine the peak height per glass fabric.
   The baseline was obtained according to the baseline drawing method described in JIS K 0117:2017. Specifically, as shown in Fig. 18 d) of JIS K 0117:2017), a tangent line was drawn in contact with two base points (for this example, the two points at the base section located on the right side of the carbonyl group-derived peak in (5) above, and the base section located on the left side), and used as the baseline. The difference between the baseline and peak top was obtained as the carbonyl group-derived peak height.
(6) The procedures of (2) to (5) above were carried out in the same manner using a heat fabric and a sample obtained by the method described below. This yielded a calibration curve for the total carbon content (mass%) or ignition loss value (mass%) (x-axis), and the carbonyl group-derived peak height per glass fabric (y-axis), for the sample. The calibration curve was obtained as an approximate line running through the origin.

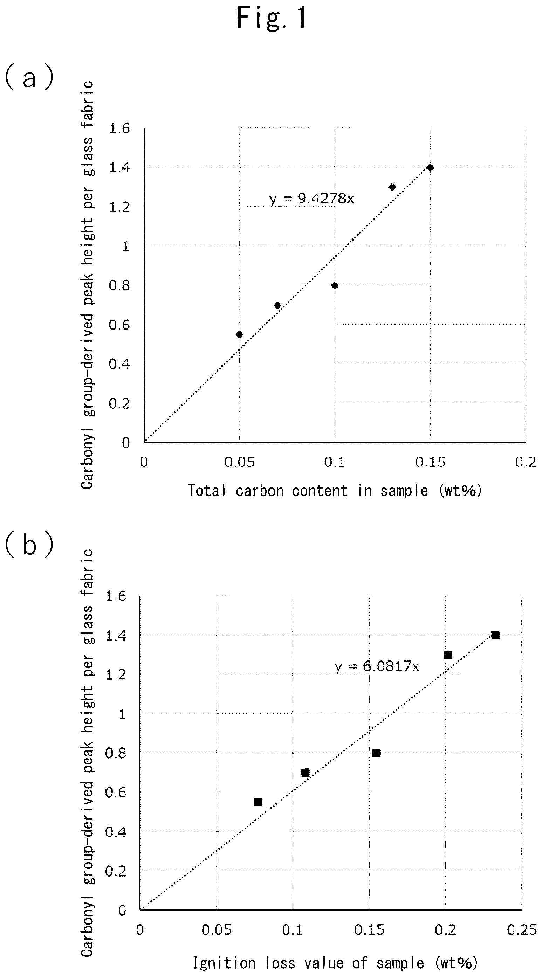

   Fig. 1 shows a calibration curve L for the Examples. Fig. 1(a) shows the relationship between peak height and total carbon content, and Fig. 1(b) shows the relationship between peak height and ignition loss value.
(7) For the calibration curve obtained in (6) above, 1.00 was set as the y-axis value (carbonyl group-derived peak height) at a total carbon content or ignition loss value for the sample of 0.1 mass%. The "peak height per glass fabric" obtained in (5) above was normalized according to the following formula:
   Peak height per glass fabric after normalization = (peak height per glass fabric before normalization × 1.00)/peak height of sample (when total carbon content or ignition loss value is 0.1 mass%). The normalized "peak height per glass fabric" was thus determined. In the formula, the "peak height per glass fabric" before normalization is the "peak height per glass fabric" obtained in (5) above.
(8) The total carbon content or the ignition loss value of the glass fabric used as a sample in (3) above and the normalized "peak height per glass fabric" obtained in (7) above were used to calculate the respective values according to the following formulas: $A = peak height per glass fabric / total carbon content in glass fabric \left(mass%\right)$ $B = peak height per glass fabric / ignition loss value of glass fabric \left(mass%\right) .$
(9) The same procedure was carried out as in (1) to (8) above, changing the number of stacked glass fabrics to five sheets. The procedure described above was carried out with a stack of five of the heat fabrics of (2) above and a stack of five of the samples of (6) above. The values for A and B were thus obtained for five glass fabrics.
(10) The same procedures of (1) to (8) above were also carried out changing the number of stacked glass fabrics to six. The procedure described above was carried out with a stack of six of the heat fabrics of (2) above and a stack of six of the samples of (6) above. This values for A and B were thus obtained for six glass fabrics.
(11) A comparison was made between the difference spectrum obtained with four glass fabric pieces, the difference spectrum obtained with five glass fabric pieces, and the difference spectrum obtained with six glass fabric pieces.

It was also established which number of glass fabrics had a difference spectrum with minimal disturbance in the shape of the difference spectrum, and the values A and B obtained for that number of glass fabrics were used as evaluation values.

While steps (1) to (11) were carried out for this Example, any unnecessary steps may be omitted or their order changed, so long as the measurement results are not affected.

### [Sample]

The warp yarn and weft yarn used were glass yarn with a SiO₂ composition of greater than 99.9 mass% (average filament diameter: 5.0 µm, number of filaments: 100, number of twists: 1.0 Z). An air jet loom was used to obtain a glass fabric having a thread count of 66 warp yarns/25 mm and 68 weft yarns/25 mm. The obtained glass fabric was heated and deoiled at 1000°C for 20 seconds. Next, the glass fabric was dipped in a surface treatment solution comprising a mixture of purified water adjusted to pH = 3 with acetic acid, and a silane coupling agent {5-hexenyltrimethoxysilane; Z6161 (product of Dow Toray Co., Ltd.) and 3-methacryloxypropyltrimethoxysilane; Z6030 (product of Dow Toray Co., Ltd.)}. After immersion, the glass fabric was removed out and heat dried at 110°C for 1 minute for surface treatment with the silane coupling agent.

A glass fabric sample was thus prepared.

The total mass% of the silane coupling agent in the surface treatment solution was adjusted with a fixed mass ratio of 5-hexenyltrimethoxysilane:3-methacryloxypropyltrimethoxysilane at 1.00:2.83, for a total carbon content in the sample of 0.05 mass%, 0.07 mass%, 0.1 mass%, 0.12 mass% or 0.15 mass%. Glass fabrics were each fabricated having a silane coupling agent coverage approximately close to the 5 points on the calibration curve.

### [Glass fabric P]

The warp yarn and weft yarn used were composed of glass yarn with a SiO₂ composition of greater than 99.9 mass%. Specifically, the warp yarn and weft yarn used were each glass yarn with an average filament diameter of 5.0 µm, 100 filaments and 1.0 Z twisting. An air jet loom was used for weaving of a 2000 m glass fabric with a plain weave structure, having a thread count of 66/25 mm warp yarns and 68/25 mm weft yarns, and a fabric width of 1300 mm. The bulk dielectric loss tangent at 10 GHz for the glass composing the glass yarn was 0.00020.

### [Glass fabric Q]

The warp yarn and weft yarn used were composed of glass yarn with a SiO₂ composition of greater than 99.9 mass%. Specifically, the warp yarn and weft yarn used were each glass yarn with an average filament diameter of 5.0 µm, 200 filaments and 1.0 Z twisting. An air jet loom was used for weaving of a 2000 m glass fabric with a plain weave structure, having a thread count of 54/25 mm warp yarns and 54/25 mm weft yarns, and a fabric width of 1300 mm. The bulk dielectric loss tangent at 10 GHz for the glass composing the glass yarn was 0.00020.

### [Glass fabric R]

The warp yarn and weft yarn used were composed of glass yarn with a SiO₂ composition of greater than 99.9 mass%. Specifically, the warp yarn and weft yarn used were each glass yarn with an average filament diameter of 4.0 µm, 50 filaments and 1.0 Z twisting. An air jet loom was used for weaving of a 2000 m glass fabric with a plain weave structure, having a thread count of 95/25 mm warp yarns and 95/25 mm weft yarns, and a fabric width of 1300 mm. The bulk dielectric loss tangent at 10 GHz for the glass composing the glass yarn was 0.00020.

### [Preparation of surface treatment solution]

The surface treatment solution was prepared by the following procedure 1) to 5).
1) The silane coupling agent was weighed out.
2) Methanol in the same amount as weighed out in 1) above was mixed with the silane coupling agent as weighed out in 1) above to prepare a silane coupling agent solution.
3) The silane coupling agent solution and 0.8 mass% of a polyoxyethylene alkyl ether were mixed with the silane coupling agent, and the mixture was stirred. After stirring for 1 minute, an aqueous acetic acid solution (60 mass% concentration) at 20 mass% with respect to the silane coupling agent was added to the silane coupling agent solution. The silane coupling agent was thus hydrolyzed.
4) A mother liquor of the aqueous acetic acid solution (pH = 3 to 4) was prepared. The silane coupling agent solution (pre-solution) obtained in 3) above was stirred for 15 minutes at room temperature (20 to 25°C). The mother liquor was then added dropwise to the silane coupling agent solution while stirring to disperse the silane coupling agent. The drip volume (dropping rate) of the mother liquor was set so that dropping of the total amount of the mother liquor was complete by 10 minutes.
5) After completing 4), the silane coupling agent solution was stirred for 2 hours at room temperature (20 to 25°C) to obtain a surface treatment solution.

According to one aspect, the "solvent" in the "step of adding a solvent to the surface treatment agent to prepare a surface treatment solution" is the aforementioned mother liquor. One example for the mother liquor is a weakly acidic aqueous solution with a pH of 3 to 4, added to disperse the hydrolyzed silane coupling agent.

### [Examples and Comparative Examples]

### (Example 1)

The glass fabric P was washed with ion-exchanged water and then dried. This removed the alkali metal ions adhering to the glass fabric surface. The glass fabric P was then heated at 1000°C for 15 seconds for heat deoiling (heating deoiling step).

A surface treatment solution was prepared by the method described above, using 1,1'-[2-[[(2-methyl-1-oxo-2-propen-1-yl)oxy]methyl]-2-[6-(trimethoxysilyl)hexyl]-1,3-propanediyl] bis(2-methyl-2-propenoate) (CAS NO: 1248412-07-8, silane coupling agent A) as the silane coupling agent, to a silane coupling agent concentration of 0.5 mass% in the surface treatment solution.

The heated deoiled glass fabric was immersed in the obtained surface treatment solution. The excess surface treatment solution was then squeezed out with an NBR rubber roll at a pressure of 0.22 MPa. The glass fabric was heat dried at 135°C for 1 minute to anchor the silane coupling agent to the surface of the glass fabric.

For this Example, temperature control (such as cooling) was carried out during surface treatment of the glass fabric, keeping the temperature of the surface treatment solution in the range of 17 to 23°C. During surface treatment of the glass fabric, carbon dioxide was bubbled through the surface treatment solution to keep the surface treatment solution pH in the range of 3.0 to 4.0.

For this Example, the surface treatment solution used for surface treatment of the glass fabric was filtered using an HDCII filter (product of Nihon Pall Ltd.). Specifically, first the surface treatment solution was passed through a filter with a pore size of 10 µm, and then the surface treatment solution was further passed through a filter with a pore size of 4.5 µm. Aggregates present in the surface treatment solution were thus collected. The filtered surface treatment solution was used for surface treatment of a glass fabric.

The surface-treated glass fabric was opened under high pressure using a spray nozzle, at a pressure of 5.0 kg/cm². Next, ultrasonic waves at a frequency of 25 kHz and an output of 0.60 W/cm² were irradiated in water for further opening treatment while reducing the excess silane coupling agent that had physically adhered onto the glass fabric. This was followed by heating at 130°C for 1 minute for drying. The glass fabric was then immersed in toluene for finishing and washing, thereby reducing degeneration of the silane coupling agent which had not formed chemical bonds with the surfaces of the glass filaments. A 2000 m length of the surface-treated glass fabric was obtained.

### (Example 2)

A surface-treated glass fabric (2000 m) was obtained by the same method as Example 1, except that the silane coupling agent used was acrylic acid, [[2-[(trimethoxysilyl)methoxy]ethyl]imino]diethylene ester (CAS NO: 3390-52-1, silane coupling agent B), and the silane coupling agent B concentration was 0.8 mass%.

### (Example 3)

A surface-treated glass fabric (2000 m) was obtained by the same method as Example 2, except that the silane coupling agent used was 2-propenoic acid, 1,1'-[2-(8,8-dimethoxy-3-oxo-2,9-dioxa-6-thia-8-siladec-1-yl)-2-[[(1-oxo-2-propen-1-yl)oxy]methyl]-1,3-propanediyl] ester (CAS NO: 1801441-80-4, silane coupling agent C).

### (Example 4)

A surface-treated glass fabric (2000 m) was obtained by the same method as Example 2, except that the silane coupling agent used was 1,1'-[2-methyl-2-[[[[3-(trimethoxysilyl)propyl]amino]carbonyl]amino]-1,3-propanediyl] di-2-propenoate (CAS NO:1239892-42-2, silane coupling agent D).

### (Example 5)

A surface-treated glass fabric (2000 m) was obtained by the same method as Example 2, except that the silane coupling agent used was 2-propenoic acid, 2-methyl-, 1-[(trimethoxysilyl)methyl]-1,2-ethanediyl ester (CAS NO: 143414-45-3, silane coupling agent E).

### (Example 6)

A surface-treated glass fabric (2000 m) was obtained by the same method as Example 2, except that the silane coupling agent used was 1,1'-[2-[[2-(9,9-dimethoxy-4-oxo-3,10-dioxa-5-aza-9-silaundec-1-yl)-11,11-dimethoxy-1,6-dioxo-5,12-dioxa-2,7-diaza-11-silatridec-1-yl]amino]-2-methyl-1,3-propanediyl] di-2-propenoate (CAS NO: 1558048-41-1, silane coupling agent F).

### (Example 7)

A surface-treated glass fabric (2000 m) was obtained by the same method as Example 1, except that the glass fabric Q was used, and the silane coupling agent used had 0.4 mass% concentrations for each of silane coupling agents A and B, for a total concentration of 0.8 mass%.

### (Example 8)

A surface-treated glass fabric (2000 m) was obtained by the same method as Example 1, except that the glass fabric R was used, and the silane coupling agent A concentration was 0.8 mass%.

### (Example 9)

A surface-treated glass fabric (2000 m) was obtained by the same method as Example 1, except that high-pressure opening with a spray nozzle was not carried out after the surface treatment.

### (Example 10)

A surface-treated glass fabric (2000 m) was obtained by the same method as Example 1, except that high-pressure opening with a spray nozzle at a pressure of 2.5 kg/cm² was carried out after the surface treatment.

### (Example 11)

A surface-treated glass fabric (2000 m) was obtained by the same method as Example 1, except that the silane coupling agent used had 0.4 mass% concentrations for each of silane coupling agent A and 3-(methacryloyloxy)propyltrimethoxysilane (CAS NO: 2530-85-0, silane coupling agent G), for a total of 0.8 mass%.

### (Comparative Example 1)

A surface-treated glass fabric (2000 m) was obtained by the same method as Example 2, except that silane coupling agent G was used.

### (Comparative Example 2)

A surface-treated glass fabric (2000 m) was obtained by the same method as Example 1, except that the silane coupling agent solution was added dropwise into the mother liquor of the stirred aqueous acetic acid solution to prepare the surface treatment solution, surface treatment of the glass fabric was carried out without filtration of the surface treatment solution, the surface treatment solution was not cooled even if the surface treatment solution temperature rose above 23°C, and carbon dioxide was not bubbled through even if the pH exceeded 4.0.

### (Comparative Example 3)

A surface-treated glass fabric (2000 m) was obtained by the same method as Example 2, except that the silane coupling agent used was 3-acryloxypropyltrimethoxysilane (CAS NO: 4369-14-6, silane coupling agent H).

### [Frequency of white spot generation]

The frequency of white spot generation on the glass fabric surface was evaluated by irradiating a halogen lamp onto an A4 size (210 mm × 297 mm) glass fabric. For a sheet-like glass fabric, a halogen lamp was set directly above the glass fabric, and the number of white spots was determined while observing the glass fabric from different directions, calculating the frequency of white spot generation according to the following formula:
Frequency of white spot generation (/m²) = number of white spots/{glass fabric area (m²)}.

For a glass fabric roll, the number of white spots generated in the glass fabric was counted across a length of 2000 m while applying a tensile force of 100 N/1300 mm to the glass fabric during irradiation with a halogen lamp on a Roll-to-Roll examining table. The frequency of white spot generation was determined according to the following formula, based on the examining area and the number of white spots found during examination: 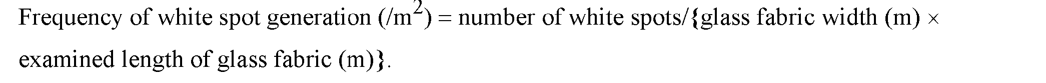 Frequency of white spot generation (/m2) = number of white spots/{glass fabric width (m) × examined length of glass fabric (m)}.

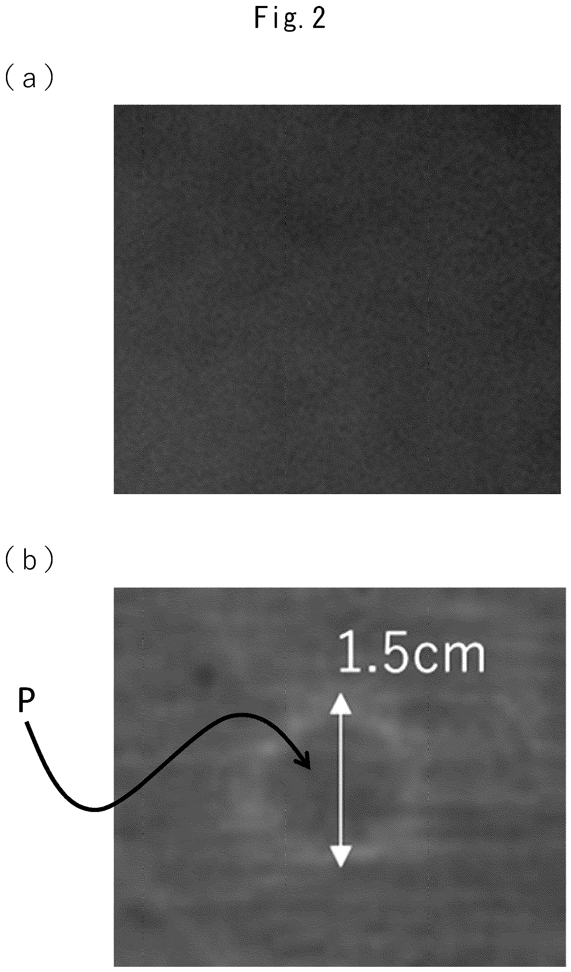

Fig. 2 is a photograph showing a "white spot", for this Example. Fig. 2(a) is a photograph showing at a location without a white spot, and Fig. 2(b) is a photograph showing a location with a white spot P.

For the Example, a "white spot" is defined as a defect where a white contour line is observed under UV light irradiation and the area enclosed by the contour line (the area including the contour line) is 0.8 cm² or greater. The outline here is circular, as an example.

The area enclosed by the contour line was calculated using known image analysis software.

### [Prepreg production method]

To a stainless steel container there were added 45 parts by mass of polyphenylene ether (Noryl SA9000, product of SABIC), 10 parts by mass of triallyl isocyanurate, 45 parts by mass of toluene and 0.6 parts by mass of 1,3-di(tert-butylisopropylbenzene), and the mixture was stirred at room temperature for 1 hour. A varnish was thus prepared.

The prepared varnish was impregnated into the glass fabrics obtained in the Examples and Comparative Examples, and then dried at 115°C for 1 minute to obtain prepregs.

### [Method for producing resin substrate]

Each obtained prepreg was sampled to a size of 20 cm × 20 cm. Eight of the obtained samples were stacked, and a 12 µm-thick copper foil was further stacked on the top level and bottom level. The stack was then heated and pressed at 200°C, 40 kg/cm² for 120 minutes to fabricate a resin substrate.

### [Soldering heat resistance]

The top and bottom copper foils were removed from the resin substrate to obtain a laminated sheet. A total of ten 5 cm × 5 cm samples were cut out from the obtained laminated sheet. These were heated in a pressure cooker container at 133°C for 72 hours and caused to absorb water. Each water-absorbed laminated sheet was then immersed for 20 seconds in a solder bath at 288°C, and each of the 10 laminated sheet samples was visually examined for any blistering due to detachment at the glass fabric/resin interface.

Laminated sheet samples with blistering due to detachment at the glass fabric/resin interface were marked as "×" (fail), and the number of "×" (fail) laminated sheet samples was evaluated. A smaller number of recorded glass fabrics indicates more excellent heat resistance.

### [Whitening distance]

The laminated sheet was cut to a size of 7 cm × 4 cm, and two 2 cm-long slits were formed on both the length and width using a diamond cutter, to prepare a test piece. The test piece was prepared by the method described in Japanese Unexamined Patent Publication No. 2020-158364.

The obtained test piece was immersed in a 1 mol/L NaOH aqueous solution and heated at 60°C for 30 hours. A digital microscope (product of Keyence Corp.) was then used for a whitening distance test to measure the whitening distance due to detachment between the resin and glass interface in the warp direction and weft direction, at 100x magnification. In the whitening distance test, the whitening distance was measured at 24 points in both the warp direction and weft direction, and the average value was calculated. The whitening distance at each level was evaluated as the improvement in whitening distance, using a relative value with respect to the value obtained in Comparative Example 1 as 1.0. Reducing the whitening distance means improving the insulating reliability for a printed circuit board. The results are shown in the tables below.

The production conditions and evaluation results for the Examples and Comparative Examples are shown in the following table. The glass fabrics of the Examples were successfully used to fabricate prepregs, printed circuit boards (resin substrates), integrated circuits and electronic devices by common methods.

### [Table 1]

**Table 1**

| | | | Example 1 | Example 2 | Example 3 | Example 4 | Example 5 | Example 6 | Example 7 |
|---|---|---|---|---|---|---|---|---|---|
| Glass fabric type | | | P | P | P | P | P | P | Q |
| Heat deoiling step | Temperature | °C | 1000 | 1000 | 1000 | 1000 | 1000 | 1000 | 1000 |
| | Time | sec | 15 | 15 | 15 | 15 | 15 | 15 | 15 |
| Surface treatment step | Surface treatment solution preparation method | - | Dropwise addition of mother liquor to silane coupling agent | Dropwise addition of mother liquor to silane coupling agent | Dropwise addition of mother liquor to silane coupling agent | Dropwise addition of mother liquor to silane coupling agent | Dropwise addition of mother liquor to silane coupling agent | Dropwise addition of mother liquor to silane coupling agent | Dropwise addition of mother liquor to silane coupling agent |
| | Surface treatment solution filtration | - | Yes | Yes | Yes | Yes | Yes | Yes | Yes |
| | Surface treatment solution temperature and pH control | - | Yes | Yes | Yes | Yes | Yes | Yes | Yes |
| | Surface treatment solution type | - | A | B | C | D | E | F | A+B |
| | Molecular weight of surface treatment solution (silane coupling agent) | - | 514.7 | 391.5 | 520.6 | 418.5 | 332.4 | 754.9 | A=514.7 |
| | | | | | | | | | B=391.5 |
| | | | | | | | | | weighted average value = 453.1 |
| | Concentration | mass% | 0.5 | 0.8 | 0.8 | 0.8 | 0.8 | 0.8 | 0.8 |
| Physical properties | Thickness | µm | 34 | 34 | 34 | 34 | 34 | 34 | 47 |
| | Basis weight | g/m² | 25.5 | 25.7 | 25.6 | 25.4 | 25.5 | 25.3 | 40.3 |
| | Ignition loss value | mass% | 0.05 | 0.10 | 0.11 | 0.10 | 0.09 | 0.13 | 0.10 |
| | Total carbon content | mass% | 0.03 | 0.06 | 0.06 | 0.05 | 0.05 | 0.07 | 0.05 |
| | Peak height per glass fabric/total carbon content | - | 30 | 20 | 28 | 19 | 21 | 40 | 25 |
| | Peak height per glass fabric/ignition loss value | - | 24 | 16 | 24 | 17 | 15 | 34 | 20 |
| | Average degree of opening | % | 60 | 68 | 56 | 61 | 60 | 50 | 57 |
| | Frequency of white spot generation | count/m² | 0.01 | 0.01 | 0.01 | 0.01 | 0.01 | 3 | 0.01 |
| | Dielectric loss tangent (@10 GHz) | - | 0.00018 | 0.00025 | 0.00028 | 0.00022 | 0.00029 | 0.00030 | 0.00029 |
| Soldering heat resistance | | | 1 | 1 | 1 | 1 | 1 | 3 | 1 |
| Whitening distance | | | 0.1 | 0.4 | 0.1 | 0.5 | 0.4 | 0.3 | 0.2 |

### [Table 2]

**Table 2**

| | | | Example 8 | Example 9 | Example 10 | Example 11 | Comp. Example 1 | Comp. Example 2 | Comp. Example 3 |
|---|---|---|---|---|---|---|---|---|---|
| Glass fabric type | | | R | P | P | P | P | P | P |
| Heat deoiling step | Temperature | °C | 1000 | 1000 | 1000 | 1000 | 1000 | 1000 | 1000 |
| | Time | sec | 15 | 15 | 15 | 15 | 15 | 15 | 15 |
| Surface treatment step | Surface treatment solution preparation method | - | Dropwise addition of mother liquor to silane coupling agent | Dropwise addition of mother liquor to silane coupling agent | Dropwise addition of mother liquor to silane coupling agent | Dropwise addition of mother liquor to silane coupling agent | Dropwise addition of mother liquor to silane coupling agent | Dropwise addition of silane coupling agent to mother liquor | Dropwise addition of mother liquor to silane coupling agent |
| | Surface treatment solution filtration | - | Yes | Yes | Yes | Yes | Yes | No | Yes |
| | Surface treatment solution temperature and pH control | - | Yes | Yes | Yes | Yes | Yes | No | Yes |
| | Surface treatment solution type | - | A | A | A | A+G | G | A | H |
| | Molecular weight of surface treatment solution (silane coupling agent) | - | 514.7 | 514.7 | 514.7 | A=514.7 | 248.4 | 514.7 | 234.3 |
| | | | | | | G=248.4 | | | |
| | | | | | | weighted average value = 381.6 | | | |
| | Concentration | mass% | 0.8 | 0.5 | 0.5 | 0.8 | 0.8 | 0.5 | 0.8 |
| Physical properties | Thickness | µm | 15 | 34 | 34 | 34 | 34 | 34 | 34 |
| | Basis weight | g/m² | 10.5 | 25.7 | 25.7 | 25.4 | 25.6 | 25.5 | 25.5 |
| | Ignition loss value | mass% | 0.10 | 0.05 | 0.05 | 0.10 | 0.07 | 0.05 | 0.10 |
| | Total carbon content | mass% | 0.06 | 0.03 | 0.03 | 0.05 | 0.04 | 0.03 | 0.05 |
| | Peak height per glass fabric/total carbon content | - | 29 | 30 | 30 | 11 | 9 | 30 | 9 |
| | Peak height per glass fabric/ignition loss value | - | 25 | 24 | 24 | 12 | 10 | 24 | 10 |
| | Average degree of opening | % | 60 | 35 | 48 | 60 | 58 | 57 | 58 |
| | Frequency of white spot generation | count/m² | 0.01 | 0.01 | 0.01 | 0.01 | 0.01 | 15 | 0.01 |
| | Dielectric loss tangent (@10 GHz) | - | 0.00030 | 0.00018 | 0.00018 | 0.00030 | 0.00025 | 0.00018 | 0.00026 |
| Soldering heat resistance | | | 1 | 3 | 1 | 1 | 1 | 10 | 1 |
| Whitening distance | | | 0.1 | 0.4 | 0.2 | 0.5 | 1.0 | 2.0 | 1.1 |

As shown by the Examples, it was possible to provide glass fabrics allowing excellent dielectric characteristics and excellent insulating reliability to be realized, and allowing further improvement in properties (for example, reduction in the resin substrate whitening distance) for resin substrates prepared using the glass fabrics. On the other hand, it was not possible to reduce the whitening distance for the obtained resin substrates in any of the Comparative Examples, and in Comparative Example 2 in particular, it was not possible to obtain excellent soldering heat resistance.

### INDUSTRIAL APPLICABILITY

The present invention can be utilized in fields related to glass fabrics and printed circuit boards (especially printed circuit boards for high-speed communication).

### REFERENCE SIGNS LIST

P: White spot

## Claims

1. A glass fabric formed by weaving glass yarn, wherein:
the glass fabric is surface-treated with a surface treatment agent,
the value of the following formula A is 10 or greater:
Formula A = Carbonyl group-derived peak height/total carbon in glass fabric, as calculated from the total carbon content in the glass fabric and the carbonyl group-derived peak height as measured by Fourier transform infrared spectroscopy, and
the number of white spots is 10/m² or less.

2. A glass fabric formed by weaving glass yarn, wherein:
the glass fabric is surface-treated with a surface treatment agent,
the value of the following formula B is 11 or greater:
Formula B = Carbonyl group-derived peak height/ignition loss value of glass fabric, as calculated from the ignition loss value of the glass fabric and the carbonyl group-derived peak height as measured by Fourier transform infrared spectroscopy, and
the number of white spots is 10/m² or less.

3. A glass fabric according to claim 1 or 2, wherein the silicon (Si) content of the glass yarn is 95.0 to 100 mass% in terms of silicon dioxide (SiO₂).

4. A glass fabric according to claim 1 or 2, wherein the dielectric loss tangent at 10 GHz is 0.002 or lower.

5. A glass fabric according to claim 1 or 2, wherein the bulk dielectric loss tangent at 10 GHz of the glass composing the glass yarn is 0.002 or lower.

6. A glass fabric according to claim 1 or 2, wherein the surface treatment agent comprises a silane coupling agent.

7. A glass fabric according to claim 1 or 2, wherein the surface treatment agent comprises a silane coupling agent represented by the following formula (1):
X₃₋ₙSiYₙ (1)
(where each X may independently comprise a different organic functional group, with X composed of a functional group having a total of at least two of both a carbonyl group and an unsaturated carbon double bond, each Y is independently an alkoxy group, and n is an integer of 1 to 3).

8. A glass fabric according to claim 7, wherein the unsaturated carbon double bond is a bond derived from either or both an acryloyl and methacryloyl group.

9. A glass fabric according to claim 1 or 2, wherein the ignition loss value of the glass fabric is 0.01 to 0.5 mass%.

10. A glass fabric according to claim 1 or 2, wherein the average degree of opening of the warp yarn and weft yarn of the glass fabric is greater than 40%, as calculated from their respective yarn widths.

11. A glass fabric according to claim 1 or 2, wherein the total carbon content in glass fabric is 0.01 to 0.8 mass%.

12. A prepreg comprising a glass fabric according to claim 1 or 2, and a matrix resin.

13. A printed circuit board comprising a prepreg according to claim 12.

14. An integrated circuit comprising a printed circuit board according to claim 13.

15. An electronic device comprising a printed circuit board according to claim 13.

16. A method for producing a glass fabric by weaving glass yarn, the method having:
a surface treatment step in which the glass yarn is treated using a surface treatment solution containing a surface treatment agent with a molecular weight of 200 or greater,
wherein the surface treatment step comprises at least one of the following steps:
a step of adding a solvent to the surface treatment agent to adjust the surface treatment solution;
a step of controlling the temperature of the surface treatment solution;
a step of controlling the pH of the surface treatment solution; and
a step of filtering the surface treatment solution.

17. The method for producing a glass fabric according to claim 16, wherein:
the surface treatment step comprises a step of surface treating the deoiled glass yarn with a surface treatment agent, and
the surface treatment agent comprises a silane coupling agent represented by the following formula (1):
X₃₋ₙSiYₙ (1)
(where each X may independently comprise a different organic functional group, with X composed of a functional group having a total of at least two of both a carbonyl group and an unsaturated carbon double bond, each Y is independently an alkoxy group, and n is an integer of 1 to 3).

18. The method for producing a glass fabric according to claim 16 or 17, wherein the surface treatment step comprises:
a step of controlling the temperature and pH of the surface treatment solution, and
a step of filtering the surface treatment solution.

19. The method for producing a glass fabric according to claim 16 or 17, which further comprises a step of opening the glass yarn after the surface treatment step.

20. The method for producing a glass fabric according to claim 16 or 17, which further comprises a step of examining white spots in the glass fabric.

21. The method for producing a glass fabric according to claim 16 or 17, which comprises a step of measuring the carbonyl group-derived peak height for the glass fabric, using Fourier transform infrared spectroscopy.

22. A test method for a glass fabric obtained by weaving glass yarn, wherein
the glass fabric is surface-treated with a surface treatment agent, and
the test method comprises a step of examining white spots in the glass fabric based on the carbonyl group-derived peak height for the glass fabric and the total carbon content in the glass fabric or the ignition loss value of the glass fabric.
